# FASCICULE DE BREVET EUROPEEN

(11) **EP 0 843 354 B1**
(45) Date de publication et mention de la délivrance du brevet: **10.09.2003**
(21) Numéro de dépôt: 97410128.9
(22) Date de dépôt: 18.11.1997
(51) Int. Cl.: H01L 21/8249, H01L 27/06

(54) **Fabrication de circuits intégrés bipolaires/CMOS**
Herstellung von integrierten bipolaren/CMOS-Schaltkreisen
Manufacture of integrated bipolar/CMOS circuits

(30) Priorité: 19.11.1996 FR 9614412
(43) Date de publication de la demande: 20.05.1998
(73) Titulaire: STMicroelectronics S.A., 92120 Montrouge (FR)
(72) Inventeur: Gris, Yvon, 38210 Tullins (FR)
(74) Mandataire: de Beaumont, Michel

(56) Documents cités:
- EP-A- 0 495 329
- EP-A- 0 646 952
- GB-A- 2 257 296
- US-A- 4 960 726
- US-A- 5 045 484
- US-A- 5 238 850
- US-A- 5 416 031
- US-A- 5 429 959
- "SIMPLIFIED BIPOLAR IN BI-CMOS" IBM TECHNICAL DISCLOSURE BULLETIN, vol. 33, no. 7, 1 décembre 1990, page 401/402 XP000108500

## Description

La présente invention concerne une filière de fabrication de circuits intégrés susceptibles de contenir notamment des composants bipolaires et MOS complémentaires (CMOS). Ce type de filière est habituellement appelé filière BICMOS.

Divers types de filières BICMOS sont connues dans la technique, par exemple dans les documents EP-A-0646952 et EP-A-0495329.

Un objet de la présente invention est de prévoir une telle filière dans laquelle les dimensions d'un élément dessiné sur un masque peuvent être d'une dimension inférieure ou égale à 0,4 µm, par exemple 0,2 à 0,35 µm.

Un objet plus particulier de la présente invention est de prévoir une telle filière dans laquelle les propriétés des composants de type MOS et celles des composants de type bipolaire sont optimisées.

Un autre objet de la présente invention est de prévoir une telle filière qui soit compatible avec des filières connues de fabrication de composants CMOS.

Un autre objet de la présente invention est de prévoir une telle filière qui soit aussi simple que possible pour atteindre les résultats visés.

Un autre objet de la présente invention est de prévoir une telle filière qui se prête à la fabrication de nombreux composants autres que les composants de base (transistors NPN, transistors MOS à canal N et transistors MOS à canal P).

Pour atteindre ces objets, la présente invention prévoit un procédé de fabrication selon la revendication 1 dans lequel on réalise successivement les couches enterrées des transistors bipolaires, les transistors CMOS, les transistors bipolaires, puis les interconnexions, pour décorréler les caractéristiques des transistors MOS de celles des transistors bipolaires et optimiser chacun de ces composants. Après formation des transistors MOS, une couche de protection permet de protéger les transistors MOS pendant la formation des transistors bipolaires. Cette même couche de protection est ensuite utilisée comme masque pour la formation de zones siliciurées.

Selon un mode de réalisation de la présente invention, la première couche d'oxyde de silicium a une épaisseur de l'ordre de 20 nm et la première couche de nitrure de silicium a une épaisseur de l'ordre de 30 nm.

Selon un mode de réalisation de la présente invention, la première couche de silicium a une épaisseur de l'ordre de 200 nm et la deuxième couche d'oxyde de silicium a une épaisseur de l'ordre de 300 nm.

Selon un mode de réalisation de la présente invention, la première couche de silicium est obtenue par dépôt de silicium amorphe non dopé puis par implantation superficielle de BF₂.

Selon un mode de réalisation de la présente invention, une zone superficielle du puits collecteur est dopée en même temps que les sources et drains des transistors MOS à canal N.

Selon un mode de réalisation de la présente invention, l'ouverture de la couche de protection à l'emplacement d'émetteur-base est moins étendue que l'ouverture correspondante dans l'oxyde épais.

Selon un aspect de la présente invention, diverses étapes du procédé sont utilisées pour la réalisation d'autres composants.

La présente invention prévoit la formation d'un transistor bipolaire à base centrale dans lequel l'ouverture de la première couche de silicium et de la deuxième couche d'encapsulation est réalisée de façon à laisser en place une zone centrale de ces couches.

La présente invention prévoit la formation d'un transistor PNP latéral dans lequel la région de base correspond à la couche épitaxiée formée au dessus d'une couche enterrée de type N⁺, la région d'émetteur est formée par la même implantation que les sources et drains des transistors MOS à canal P, et la région de collecteur est formée à partir d'une portion de la première couche de silicium polycristallin.

La présente invention prévoit la formation d'un transistor MOS résistant aux décharges électrostatiques comprenant un transistor MOS dont le contact de drain est repris par une portion de la première couche de silicium polycristallin s'étendant au-dessus d'une partie du substrat et servant également à établir une diffusion prolongeant la zone de drain.

La présente invention prévoit la formation d'un transistor MOS haute tension formé dans un caisson P isolé, tel que sa couche d'isolement de grille correspond à une portion de la couche de protection comprenant une première couche d'oxyde de silicium et une première couche de nitrure de silicium, sa grille est formée à partir de la première couche de silicium polycristallin dopé et est revêtue de la deuxième couche d'oxyde d'encapsulation, sa grille est encadrée latéralement d'espaceurs constitués par la deuxième couche de nitrure de silicium et la deuxième couche de silicium polycristallin, et ses régions de reprise de contact de source et de drain sont formées de zones dopées par diffusion à partir d'un dépôt de portion de la troisième couche de silicium polycristallin.

La présente invention prévoit la formation d'un transistor EPROM tel que sa première grille, les espaceurs associés et ses source et drain sont formés en même temps que ceux des transistors MOS, son isolant entre grilles correspond à une portion de ladite couche de protection, et sa deuxième grille correspond à la première couche de silicium polycristallin.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 11 sont des vues en coupe schématique illustrant des étapes successives de fabrication d'un mode de réalisation d'un transistor MOS à canal N, d'un transistor MOS à canal P et d'un transistor bipolaire de type NPN selon la présente invention ;
la figure 12A est une vue agrandie d'un transistor bipolaire de type NPN obtenu selon la présente invention ;
les figures 12B à 12E représentant diverses variantes de la structure de la figure 12A ;
les figures 13A à 13C représentent des étapes successives de fabrication d'une variante, à base centrale, de transistor NPN que l'on peut réaliser en utilisant le procédé de fabrication selon la présente invention ;
la figure 14 représente un exemple de transistor PNP que l'on peut réaliser en utilisant le procédé de fabrication selon la présente invention ;
la figure 15 représente un exemple de transistor MOS résistant aux surtensions ou décharges électrostatiques, que l'on peut réaliser en utilisant le procédé de fabrication selon la présente invention ;
la figure 16 représente un exemple de transistor MOS pouvant supporter des hautes tensions destiné à être associé à un circuit de mémoire, que l'on peut réaliser en utilisant le procédé de fabrication selon la présente invention ; et
la figure 17 représente un exemple de structure EPROM que l'on peut obtenir en utilisant le procédé selon la présente invention.

Comme cela est usuel dans le domaine de la représentation des composants semiconducteurs, les diverses vues en coupe ne sont pas tracées à l'échelle. Les dimensions latérales et transversales des diverses couches et régions sont arbitrairement dilatées ou rétrécies pour faciliter le tracé des figures.

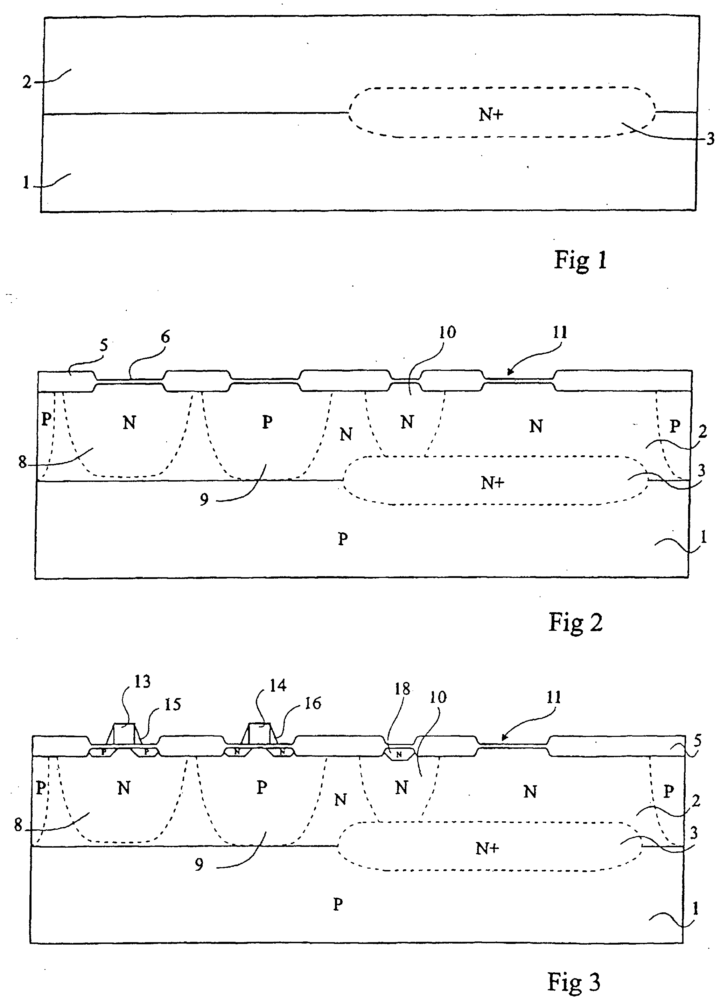

De façon générale dans la suite de la description, on désignera le côté gauche des figures 1 à 11 dans lequel est formé un composant CMOS par l'appellation côté CMOS et le côté droit de ces figures dans lequel est formé un transistor bipolaire de type NPN par l'appellation côté bipolaire. Dans ce qui suit, on décrit la fabrication d'un transistor MOS à canal N, d'un transistor MOS à canal P et d'un transistor bipolaire de type NPN. Bien entendu, dans une réalisation pratique, on formera simultanément de nombreux composants identiques, ainsi qu'éventuellement d'autres types de composants élémentaires.

Selon un aspect de la présente invention, les étapes initiales correspondent à des étapes connues de fabrication de circuits intégrés CMOS de très petites dimensions (dimension minimum, ou dimension de grille, inférieure à 0,35 µm).

Comme le représente la figure 1, on part d'un substrat 1 de type P sur lequel est formée une couche épitaxiale 2 de type N. Cette couche épitaxiale est relativement mince, par exemple d'une épaisseur de l'ordre de 1 à 1,2 µm.

Avant la croissance de la couche épitaxiale, on prévoit si on le souhaite des couches enterrées de types appropriés dans les zones où doivent être formés des caissons N ou P de transistors CMOS et l'on forme une couche enterrée 3 de type N⁺ du côté bipolaire.

Comme le représente la figure 2, du côté MOS, on délimite les régions des transistors MOS par des ouvertures dans une couche d'oxyde épais 5 formée par toute technique connue. On implante, à travers l'oxyde épais ou une région d'oxyde mince 6 formée dans les ouvertures, des caissons 8 de type N et des caissons 9 de type P, de façon classique. Ces caissons sont par exemple formés par une succession de trois implantations dont l'une traverse l'oxyde épais 5 dans des régions non-masquées. Ces caissons N et P sont destinés respectivement à des transistors MOS à canal P et à des transistors MOS à canal N. Le niveau de dopage en surface (quelques 10¹⁶ at./cm³) détermine la tension de seuil des transistors. Dans le cas général, les caissons P (associés à une couche enterrée P⁺) sont en contact électrique avec le substrat P. On pourra toutefois prévoir de former certains au moins des caissons P sur une couche enterrée de type N. Les caissons N sont complètement isolés puisqu'ils débouchent dans le substrat P et ils sont isolés latéralement par des régions P formées comme les caissons P.

Simultanément, côté bipolaire, on délimite dans l'oxyde épais 5 une région dans laquelle sera formée une diffusion profonde de reprise de contact de collecteur ou puits collecteur 10 rejoignant la couche enterrée 3. Ce puits collecteur est formé par au moins certaines des implantations réalisées pour former le caisson 8 de type N, ou bien par une implantation spécifique de type N⁺. Ce puits collecteur peut aussi être formé ultérieurement en même temps que les sources et drains des transistors MOS à canal N. Egalement, on délimite dans l'oxyde épais une zone 11 dans laquelle seront formés la base et l'émetteur d'un transistor bipolaire de type NPN. Pendant les diverses implantations de caissons N et P, cette zone 11 est masquée.

Comme le représente la figure 3, du côté MOS, on forme de façon classique des grilles isolées 13 et 14 des transistors MOS ; on réalise des premières implantations (LDD) ; on forme des espaceurs 15 et 16 ; et on réalise des implantations de drains et de sources. Dans le caisson 8, les implantations sont de type P et, dans le caisson 9, les implantations sont de type N. En même temps que l'on fait les implantations de sources et de drains des transistors à canal N dans les caissons P, on réalise une diffusion de type N fortement dopée 18 à la surface du puits collecteur 10 pour améliorer la prise de contact ultérieure.

On effectue ensuite un recuit thermique rapide (1025°C).

Après cette étape, à la fin de laquelle l'essentiel des transistors MOS a été réalisé (sauf les éventuelles siliciurations de prise de contact et les métallisations), on procède à la réalisation du transistor bipolaire de type NPN.

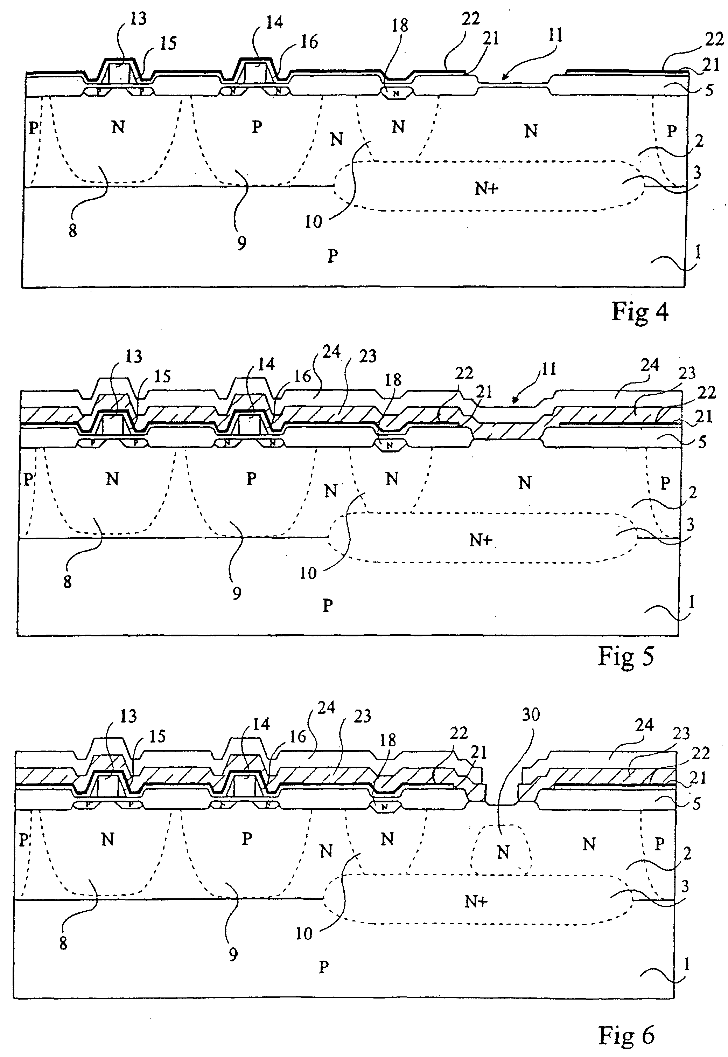

A l'étape illustrée en figure 4, on dépose sur l'ensemble de la structure, par voie chimique en phase vapeur, une double couche de protection comprenant une couche d'oxyde de silicium 21 ayant par exemple une épaisseur de l'ordre de 20 nm suivie d'une couche de nitrure de silicium 22 ayant par exemple une épaisseur de l'ordre de 30 nm. Cette couche 21-22 est ouverte dans la zone 11 où l'on souhaite former la région émetteur-base d'un transistor bipolaire. On notera que cette ouverture n'est pas critique puisqu'elle s'arrête sur des régions d'oxyde épais.

A l'étape illustrée en figure 5, on dépose sur l'ensemble de la structure une couche de silicium 23 ayant par exemple une épaisseur de l'ordre de 200 nm suivie d'une couche d'oxyde d'encapsulation 24 ayant par exemple une épaisseur de l'ordre de 300 nm.

La couche de silicium 23 doit être dopée de type P puisqu'elle servira comme on le verra ci-après de source de dopage pour la base extrinsèque du transistor NPN et sera appelée silicium polycristallin de base. Bien qu'elle soit désignée sous l'appellation silicium polycristallin, il pourra aussi s'agir de tout type de couche de silicium déposé, par exemple du silicium amorphe. De préférence, selon un aspect de la présente invention, on procède d'abord au dépôt d'une couche 23 de silicium polycristallin ou amorphe non dopé et l'on procède ensuite à une implantation d'un dopant de type P dans cette couche. De préférence, on implante du bore sous forme de BF₂ à très forte dose (10¹⁵ à 10¹⁶ at./cm²) et à faible énergie de sorte que le bore implanté se concentre dans la partie supérieure de la couche en évitant toute implantation de bore dans le substrat de silicium sous-jacent dans la région 11.

A l'étape illustrée en figure 6, on procède à une ouverture des couches 24 et 23 dans la partie centrale de la région 11. Cette ouverture a par exemple une largeur comprise entre 0,4 et 0,8 µm et pénètre dans le silicium monocristallin de moins de 50 nm. On procède ensuite à une implantation d'un dopant de type N pour définir le collecteur 30 du transistor NPN. Ce collecteur est donc auto-aligné sur l'ouverture. L'implantation N est réalisée à dose moyenne et forte énergie (par exemple, 10¹² à 10¹⁴ at./cm² sous 500 keV). On obtient ainsi une région effective de collecteur d'étendue latérale limitée, sensiblement égale à celle de la base intrinsèque qui est formée ensuite. Ceci contribue à l'obtention d'un transistor NPN de faible capacité parasite entre collecteur et base extrinsèque. L'implantation est optimisée (par exemple, par implantations successives) pour que le profil du collecteur fournisse le meilleur compromis possible entre, d'une part, la résistance de collecteur et le temps de transit dans ce collecteur et, d'autre part, l'obtention de tensions de claquage suffisamment élevées émetteur-collecteur (typiquement 4 volts) et base-collecteur et d'une faible capacité base-collecteur. On notera aussi que cette implantation de collecteur permet de choisir au préalable une couche épitaxiée 2 de dopage et d'épaisseur propres à optimiser les transistors CMOS et d'optimiser ensuite indépendamment les caractéristiques des transistors NPN. Notamment, cette couche épitaxiée pourra être plus épaisse que si elle devait servir directement de couche de collecteur du transistor NPN.

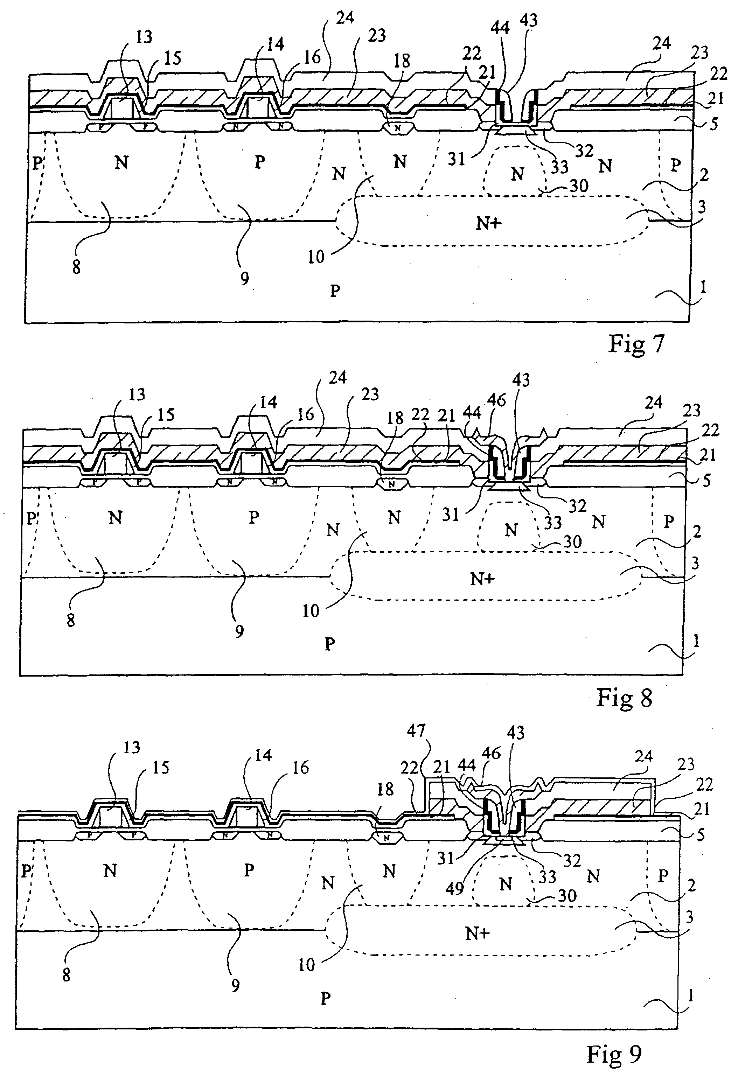

Comme le représente la figure 7, après élimination de la résine de masquage, on procède à une oxydation thermique pendant laquelle il se forme une mince couche d'oxyde thermique 31 d'une épaisseur de l'ordre de 5 à 10 nm et pendant laquelle le bore contenu dans la couche de silicium polycristallin 23 commence à diffuser dans la couche épitaxiée sous-jacente pour former une région de base extrinsèque 32 ayant par exemple une profondeur de jonction de l'ordre de 100 nm. Cette diffusion est ensuite complétée par le recuit final de la structure bipolaire. On procède alors à une implantation de type P à travers l'oxyde 31 pour former une région de base intrinsèque 33 au centre de l'ouverture dans les couches 23 et 24. Cette base intrinsèque est de préférence implantée au bore à faible énergie (par exemple, 10¹³ at./cm² sous 5 keV). Le contact avec le silicium polycristallin 23 résulte de la diffusion latérale du bore du silicium polycristallin.

On procède alors à un dépôt uniforme d'une couche mince de nitrure de silicium (30 nm) revêtue d'une couche de silicium polycristallin (100 nm). La couche de silicium polycristallin est ensuite gravée de façon anisotrope de façon qu'il n'en demeure que des espaceurs 43 sur les flancs de l'ouverture ménagée dans les couches 23 et 24. On procède ensuite à une gravure uniforme du nitrure de silicium, de sorte que ce nitrure de silicium reste en place seulement dans les régions 44 où il est protégé de la gravure (chimique ou plasma) par les espaceurs 43 de silicium polycristallin. L'ensemble du nitrure 44 et des espaceurs 43 définit donc une ouverture plus petite que l'ouverture initialement formée dans les couches 23 et 24 pour la définition de la base intrinsèque. Cette ouverture plus petite est l'ouverture d'émetteur. Si les espaceurs ont une largeur de l'ordre de 150 nm chacun, cette petite ouverture a une largeur de l'ordre de 0,5 µm.

A l'étape illustrée en figure 8, la couche mince d'oxyde 31 au fond de l'ouverture, qui avait servi de protection pendant l'implantation d'émetteur (bore) et d'arrêt de gravure de la couche de nitrure de silicium, est soigneusement nettoyée, par exemple dans un bain d'acide fluorhydrique dilué. On dépose une couche de silicium polycristallin fortement dopé de type N qui est ensuite gravée pour laisser en place une région 46. Des régions de la couche de silicium polycristallin dopé 46 peuvent être maintenues en place en des endroits choisis pour former par exemple des condensateurs entre des régions de ce silicium polycristallin 46 et des régions du silicium polycristallin de base 23.

On notera que, pendant les étapes de fabrication du transistor NPN, les régions où ont été formés les transistors MOS sont protégées par la couche d'oxyde 21, la couche de nitrure 22, la couche de silicium polycristallin de base 23 et la couche d'oxyde 24. Cet empilement de couches assure une protection très efficace contre toute pollution éventuelle et contre toute traversée par les dopants implantés pour la formation du transistor bipolaire.

A l'étape illustrée en figure 9, on élimine les couches d'oxyde 24 et de silicium polycristallin de base 23 en dehors de la région d'émetteur-base du transistor bipolaire et d'autres régions éventuelles comportant des dispositifs utilisant des portions de la couche de silicium polycristallin de base 23 (résistances, capacités...). Puis l'on dépose une couche d'oxyde de silicium d'encapsulation 47.

Après cela, on procède à un recuit de pénétration du dopant contenu dans la couche de silicium polycristallin 46 au centre de la région de base du transistor pour former son émetteur 49 de type N. Les recuits associés au transistor bipolaire assurent une réactivation électrique des dopants et conduisent à des profondeurs de jonction de l'ordre de 60 nm. Les recuits sont du type recuit thermique rapide et/ou au four. Le traitement thermique (30 s, 1000°C) est plus léger que pour les transistors MOS qui ne sont donc pas affectés.

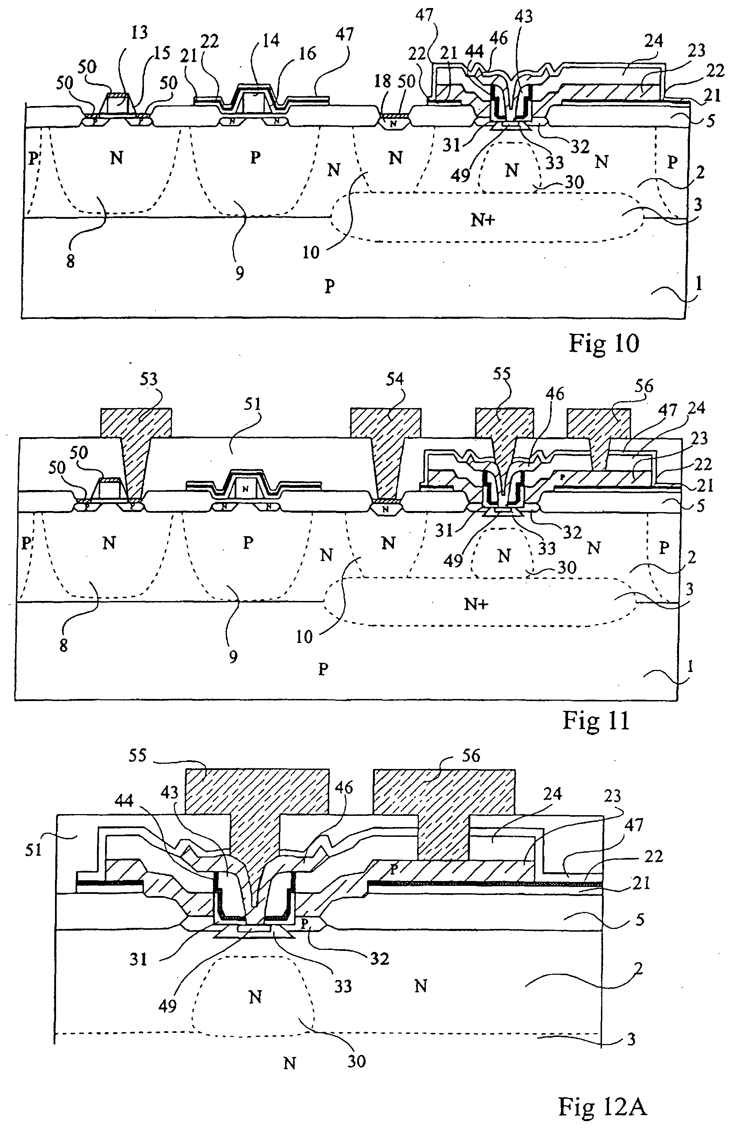

A l'étape illustrée en figure 10, on élimine les couches d'oxyde de silicium d'encapsulation 47, de nitrure de silicium 22 et d'oxyde de silicium de protection 21 au-dessus des zones actives et/ou de silicium polycristallin que l'on souhaite siliciurer, par exemple le transistor MOS à canal P et le puits collecteur du transistor bipolaire. Un siliciure métallique 50 est formé sélectivement au-dessus des régions exposées de silicium mono et polycristallin.

A l'étape illustrée en figure 11, on procède au dépôt d'une couche isolante de planarisation 51 par tout procédé connu, par exemple par dépôt d'une couche de verre dopé au bore et au phosphore (BPSG) et recuit, puis on ouvre cette couche et d'éventuelles couches sous-jacentes aux emplacements où l'on veut prendre des contacts. Seuls certains contacts ont été représentés car, comme cela est bien connu, les contacts ne sont pas nécessairement pris directement au-dessus des zones utiles mais éventuellement sur des prolongements transverses de régions conductrices s'étendant à partir de ces zones utiles. Ainsi, en figure 11, on a seulement représenté un contact de drain 53 d'un transistor MOS à canal P, un contact de collecteur 54, un contact d'émetteur 55 et un contact de base 56 du transistor bipolaire.

La figure 12A correspond au côté bipolaire de la figure 11 et représente la région d'émetteur-base du transistor bipolaire à plus grande échelle.

Dans un mode de réalisation particulier, et pour donner un exemple d'ordres de grandeur, on pourra choisir de réaliser une structure avec les données numériques suivantes (où e désigne une épaisseur, et Cs une concentration superficielle ou une concentration moyenne pour une couche homogène) :

| | |
|---|---|
| substrat 1 | Cs = 10¹⁵ at./cm³, |
| couche épi 2 | Cs = 10¹⁶ at./cm³, e = 0,8 à 1,4 µm, |
| couche enterrée 3 | Cs = 10²⁰ at./cm³, |
| oxyde 5 | e = 0,5 µm, |
| sources et drains N ou P | Cs = 10²⁰ at./cm³, e = 0,15 µm. |

Le procédé de fabrication selon la présente invention, tout en étant parfaitement compatible avec les filières existantes de fabrication de transistors CMOS à haute définition, permet de réaliser un transistor bipolaire dont les régions de collecteur, de base intrinsèque et d'émetteur sont auto-alignées.

Ce transistor bipolaire présente de nombreux avantages. Ses performances ne souffrent pas de la présence des transistors CMOS. Il peut en particulier être utilisé aux radiofréquences (fréquence de coupure supérieure à 40 GHz). La très forte transconductance et le faible bruit du transistor bipolaire le rendent apte à des applications analogiques. En particulier, le contact de base (en silicium polycristallin P⁺) permet une forte réduction de la résistance de base d'où un facteur de bruit RF intéressant. Ainsi, le transistor bipolaire peut être utilisé en lieu et place de certains transistors AsGa avec un coût moindre et la possibilité de l'associer sur une même puce à un circuit CMOS très performant.

On soulignera à nouveau que le procédé selon l'invention présente notamment les caractéristiques suivantes :
- il comporte trois phases indépendantes, de réalisation des transistors CMOS, de réalisation des transistors bipolaires, et de réalisation des siliciurations et interconnexions ;
- l'ensemble des couches de protection 21, 22 est utilisé plusieurs fois, notamment, dans une première phase, pour protéger les transistors MOS pendant la réalisation des transistors bipolaires et, dans une deuxième phase, pour protéger les éléments que l'on ne souhaite pas siliciurer ;
- les processus thermiques à appliquer au transistor bipolaire sont "froids" vis-à-vis des transistors MOS ; ceci résulte essentiellement du fait que la plupart des diffusions des transistors bipolaires résultent de couches de silicium polycristallin dopées ;
- le silicium polycristallin de base est découpé en deux fois, des espaceurs localisés étant prévus uniquement autour de l'ouverture d'émetteur ; et
- comme on va le décrire ci-après, ce procédé se prête bien à la réalisation de divers composants élémentaires autres que des transistors MOS à canal N et à canal P et des transistors bipolaires de type NPN.

### A. SILICIURATION DE LA BASE ET/OU DE L'EMETTEUR

Comme on l'a indiqué ci-dessus, une fois le transistor bipolaire formé et recuit, le processus standard CMOS reprend avec une siliciuration auto-alignée (figure 10). Cette siliciuration sélective nécessite une mise à nu du silicium à siliciurer, suivie d'un dépôt métallique (par exemple du titane, Ti) et d'un recuit. Durant ce recuit, le dépôt métallique interagit avec le silicium pour former un siliciure (par exemple TiSi₂). Le métal n'ayant pas réagi, Ti, est sélectivement éliminé dans un bain chimique sans utilisation de masque. L'important pour cette étape de siliciuration est de découvrir des zones de silicium monocristallin ou polycristallin.

Le procédé décrit est compatible avec une siliciuration de la base et/ou de l'émetteur du transistor bipolaire. Ces étapes étant entièrement compatibles avec les étapes connues auparavant en CMOS, en ajoutant uniquement des contraintes supplémentaires sur les procédés utilisés et non des étapes de processus en plus.

L'ouverture du masque de siliciuration se fait pour la technologie CMOS en gravant la couche de protection comportant les couches 21 et 22 et appelée SIPROT (voir figure 10). Côté CMOS, il faut graver respectivement les couches 47, 22 et 21. Côté bipolaire, on gravera la couche 47 avec arrêt sur le silicium polycristallin 46 pour la région d'émetteur, et les couches 47 et 24 avec arrêt sur le silicium polycristallin de base 23 pour la région de base.

Suivant les procédés de gravure, il est possible de surgraver l'oxyde 47 (100 nm) au-dessus de la région CMOS de l'épaisseur de l'oxyde 24 (300 nm) sans attaquer de façon significative le nitrure 22 et le silicium polycristallin d'émetteur 46. De la même façon, la gravure du nitrure 22 (30 nm) se fera pratiquement sans surgraver les siliciums polycristallins 23 et 46 découverts. Enfin, la gravure de l'oxyde 21 se fait sans surgravure des couches 23 et 46.

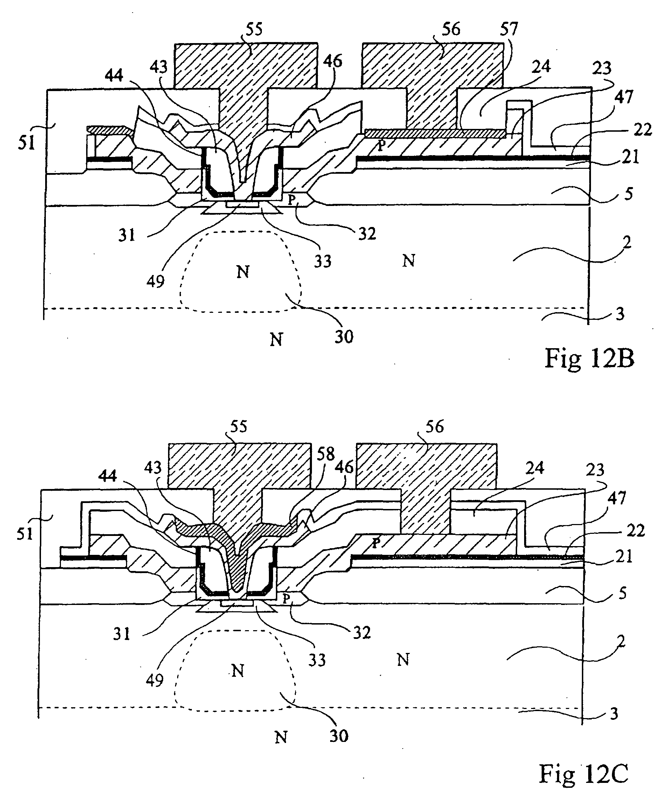

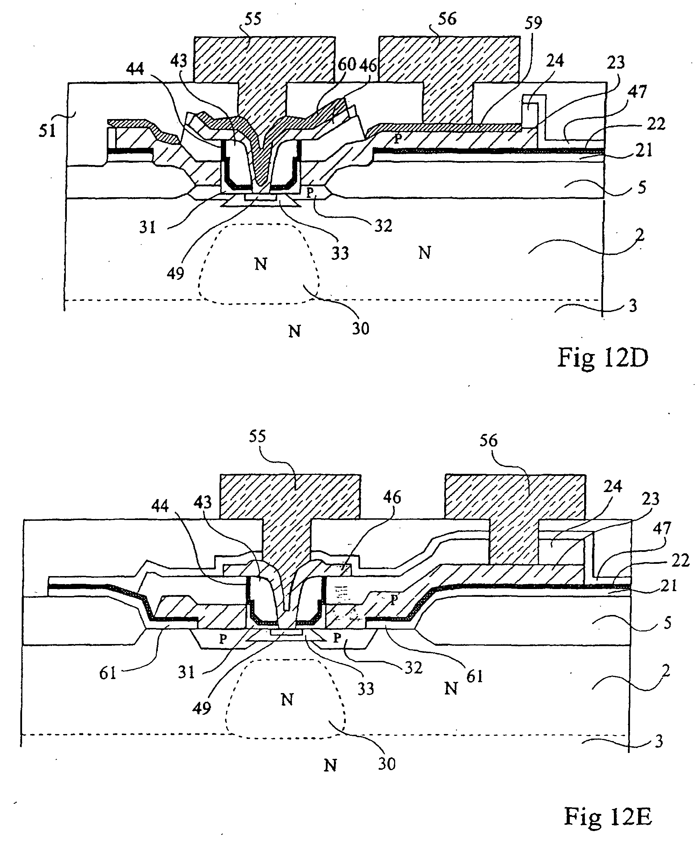

On peut donc ouvrir sélectivement le silicium polycristallin de base pour former le siliciure 57 (figure 12B), le silicium polycristallin d'émetteur pour former un siliciure 58 (figure 12C). Une siliciuration auto-alignée est même faisable aisément (figure 12D) pour former des siliciures 59, 60. En effet, l'importance de la couche 24 (300 nm) permet de faire un espaceur vertical évitant les courts-circuits des siliciures de base et d'émetteur.

Le fait de siliciurer l'émetteur permet de prendre des contacts compatibles avec le procédé CMOS, et de diminuer la résistance de contact d'émetteur.

Le fait de siliciurer la base est très bénéfique pour la résistance de base (réduction du bruit) et pour la qualité des contacts.

### B. TRANSISTOR A BASE NON MUREE

La tenue en tension entre la base et le collecteur est un paramètre critique pour cette technologie. En effet, plus la couche épitaxiée 2 est de faible épaisseur et fortement dopée, plus les performances en vitesse sont élevées au détriment de la tenue en tension collecteur-émetteur et collecteur-base, VB_{CE0} et VB_{CB0}, du dispositif. Ces tenues en tension doivent rester supérieures à la tension d'alimentation (3,3 volts).

Or, le point de jonction entre l'oxyde épais 5 et le silicium dopé P 32 de la base extrinsèque du transistor bipolaire est un point faible pour la tenue en tension, particulièrement à cause des contraintes dans le silicium et à cause de la déformation "topologique" des lignes de potentiel. Il est donc intéressant de réaliser des bases P dans le silicium monocristallin, non murées par l'oxyde épais, afin d'accroître la tension de claquage.

Ainsi, selon une variante de la présente invention, à l'étape illustrée en figure 4, au lieu d'arrêter l'ouverture des couches 21, 22 sur la couche d'oxyde épais 5 à l'extérieur de l'ouverture 11 définie préalablement dans celle-ci, on pourra définir une ouverture dans les couches 21, 22 interne à l'ouverture 11.

Le résultat de cette variante est illustré en figure 12E où le prolongement interne des régions 21, 22 est désigné par la référence 61.

Les conséquences de cette variante sont alors multiples. L'ouverture devient critique, mais on obtient une meilleure définition de la zone de contact silicium polycristallin de base/silicium monocristallin ; la surface de contact entre le silicium polycristallin de base et le silicium monocristallin peut être diminuée ; la capacité entre la base extrinsèque et le collecteur est plus faible ; le bruit basse fréquence est réduit et la tenue en tension VB_{CB0} est plus élevée.

### C. TRANSISTOR NPN À BASE CENTRALE

Les figures 13A à 13C représentent des étapes de fabrication d'une structure de transistor NPN à base centrale compatible avec la filière selon la présente invention.

La figure 13A se situe à une étape du procédé de fabrication ultérieure à celle illustrée en figure 5. Au lieu, comme cela a été représenté en figure 6, de dégager la couche de silicium 23 et la couche d'oxyde d'encapsulation 24 au centre de l'ouverture 11 définissant les régions d'émetteur et de base du transistor NPN, on laisse en place une portion 63 des couches 23 et 24 sensiblement au centre de l'ouverture 11 (qui, dans le mode de réalisation représenté, est illustrée dans le cadre de la variante non murée décrite en relation avec la figure 12E). On procède alors aux étapes décrites en relation avec la figure 6, à savoir :
- implantation du collecteur 30 qui a alors une forme annulaire,
- formation d'une couche d'oxyde thermique 31, diffusion du bore contenu dans le silicium polycristallin 23 pour former la région de base extrinsèque centrale 32, et
- implantation d'une région de base intrinsèque 33 qui, cette fois-ci, est périphérique par rapport au contact de base 23.

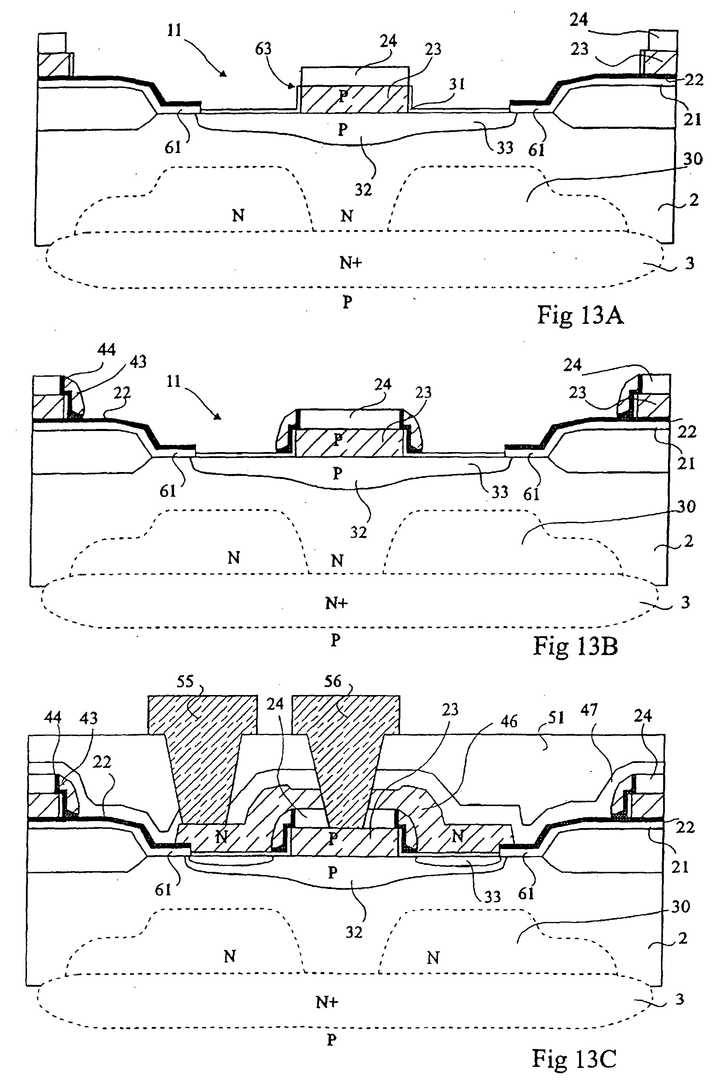

La figure 13B correspond aux étapes illustrées en figure 7 et la figure 13C à l'état final de la structure telle qu'illustrée précédemment en figure 12.

La structure illustrée en figure 13 constitue un nouveau type de transistor bipolaire entièrement compatible avec le processus décrit précédemment et ayant un rapport de surface émetteur/base très agrandi. Ce rapport permet de rendre minimum la capacité base-collecteur par rapport à la capacité base-émetteur. De plus la structure circulaire à prise de contact centrale minimise la résistance d'accès à la base pour une surface de base extrinsèque donnée. Enfin, il faut noter que dans cette structure, comme dans celle illustrée en figure 12E, il n'y a pas de contact entre la base intrinsèque et l'oxyde épais. Ceci constitue un avantage de fiabilité et de tenue en tension base-collecteur.

Toutes ces caractéristiques contribuent à l'obtention d'une fréquence de fonctionnement élevée et d'un facteur de bruit faible.

### D. TRANSISTOR PNP LATÉRAL

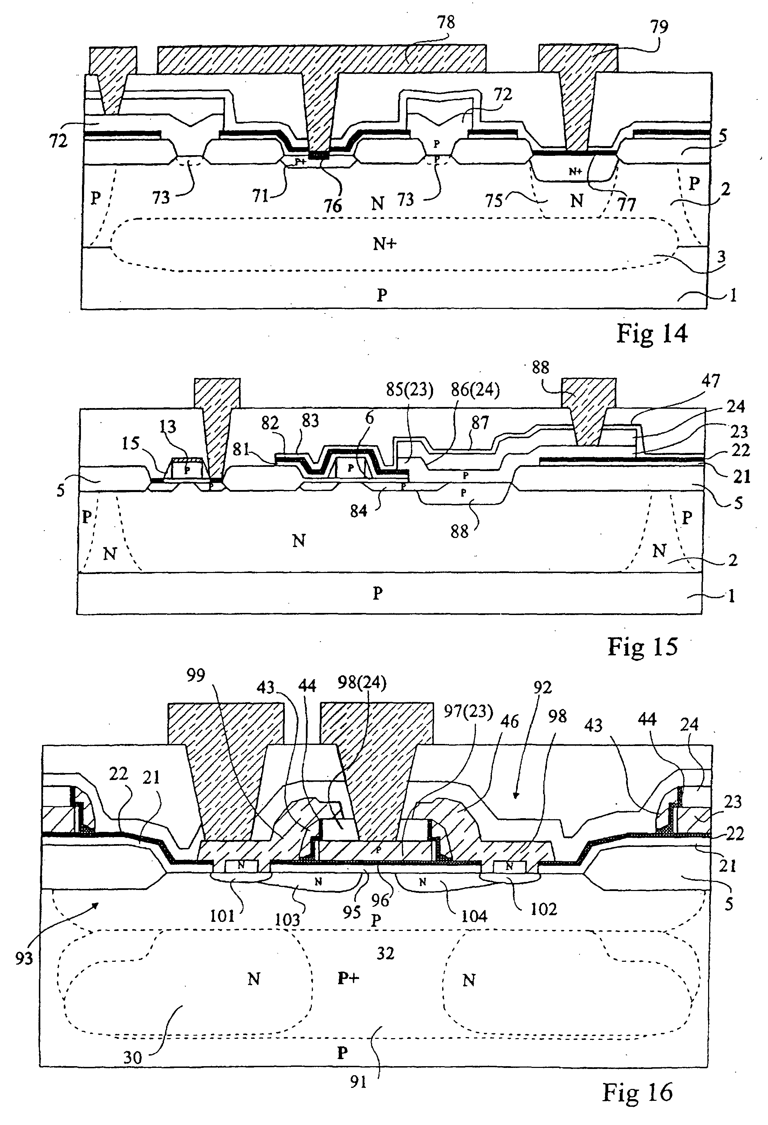

La figure 14 représente une structure de transistor PNP latéral compatible avec la filière selon la présente invention.

Ce transistor est formé dans la couche épitaxiée 2 au-dessus d'une portion de couche enterrée 3 de type N⁺. Dans la couche d'oxyde épais 5 est ménagée une ouverture centrale dans laquelle est formée une région d'émetteur 71 de type P par la même implantation que les sources et drains des transistors MOS à canal P. Dans la couche 5 est également formée une ouverture périphérique à cette ouverture centrale. Cette ouverture périphérique est surmontée d'une portion 72 de silicium polycristallin dopé de type P, correspondant à la région de silicium polycristallin de base 23 décrite précédemment. Par diffusion, la portion de silicium polycristallin 72 crée des zones de collecteur 73. En outre, une troisième ouverture est dégagée dans la couche d'oxyde épais pour former un caisson 75 de contact de base de type N⁺, en même temps que l'on forme le caisson de collecteur du transistor NPN. Ce caisson 75 rejoint la couche enterrée 3.

De préférence, lors des étapes de siliciuration, on créera des couches de siliciure 76, 77 en surface de la zone d'émetteur 71 et du caisson 75. On a également représenté des métallisations 78 et 79, respectivement d'émetteur et de base. Selon un aspect de la présente invention, la métallisation d'émetteur 78 s'étend au-dessus de l'anneau de base compris entre l'anneau de collecteur 73 et la région d'émetteur 71 pour fournir un effet de plaque de champ.

On pourra optimiser de diverses manières le gain de ce transistor PNP.

Le fait que la prise de base se fasse par la couche enterrée N⁺ constitue a priori un inconvénient puisque cette couche enterrée N⁺ est une zone de base recombinante qui augmente fortement le courant de base et diminue le gain du transistor. Toutefois, comme on l'a vu précédemment, du fait que l'on a utilisé des implantations de collecteur spécifiques pour les transistors NPN, on a pu conserver une couche épitaxiée 2 relativement épaisse, ce qui optimise le fonctionnement des transistors MOS et, pour le transistor PNP, contribue également à pallier l'effet de diminution de gain lié à l'effet de base recombinante.

La structure de l'émetteur (71, 76) est optimisée. On a indiqué que l'implantation d'émetteur 71 était la même que celle des sources et drains des transistors MOS à canal P. Dans le cas où l'on réalise dans la structure un transistor PNP, on réduira volontairement cette dose d'implantation, ce qui ne constitue pas un inconvénient pour les sources et drains des transistors MOS qui sont siliciurés. Cette réduction de la concentration des dopants P dans l'émetteur optimise (réduit) le courant de base en évitant une recombinaison directe des porteurs minoritaires (électrons) dans cet émetteur. Cet effet est renforcé par le fait que la zone siliciurée 76 sur l'émetteur 71 a une surface réduite.

Le silicium polycristallin de base (désigné par la référence 23) qui est utilisé pour former les régions 72 de contact et de diffusion de collecteur, sert à établir le contact avec le collecteur. Ceci fournit plusieurs avantages. La jonction est de très bonne qualité sans défaut avec une forte tenue en tension base-collecteur par rapport à une jonction implantée. Ceci permet aussi, comme cela a été indiqué précédemment, de prolonger le niveau de métal 78 au-dessus des régions de collecteur. Ceci fournit un effet d'écran qui permet une stabilisation du transistor et améliore fortement ses caractéristiques en vieillissement. De plus, l'écran réalisé par la couche de silicium polycristallin 72 stabilise l'extérieur de la structure entre le collecteur et le substrat.

On a ainsi obtenu un transistor PNP de caractéristiques satisfaisantes pouvant avoir un gain de l'ordre de 60, tout en utilisant uniquement les étapes technologiques décrites précédemment pour la formation de transistors CMOS et d'un transistor NPN.

### E. TRANSISTOR MOS RÉSISTANT AUX DÉCHARGES ÉLECTROSTATIQUES

La figure 15 représente une structure de transistor MOS résistant aux décharges électrostatiques et compatible avec la filière selon la présente invention.

Dans la partie gauche de la figure, on a représenté à titre de comparaison un transistor MOS à canal P classique dans lequel les drain, source et grille sont siliciurés.

Le transistor résistant aux décharges électrostatiques est formé dans une ouverture plus grande que celle d'un transistor MOS classique. On voit, dans la partie gauche de la figure, une structure de drain, source et grille classique revêtue d'une portion restante 81 de la couche d'oxyde 21, d'une portion restante 82 de la couche de nitrure de silicium 22, et d'une portion restante 83 de la couche d'oxyde de silicium 47 décrite précédemment. La région de drain 84 s'étend vers la droite de la figure vers une ouverture ménagée dans les couches 81, 82 vers la région d'oxyde épais 5. Dans cette ouverture est laissée en place une portion 85 de la couche de silicium polycristallin de base 23 revêtue de portions de couches d'oxyde 86 et 87 correspondant aux couches d'oxyde 23 et 24 susmentionnées. L'ensemble de ces couches 85, 86, 87 s'étend vers la droite au-dessus de l'oxyde épais (et partiellement au-dessus des couches d'oxyde et de nitrure de silicium 21 et 22) et un contact 88 est pris sur la couche de silicium polycristallin 85 de façon éloignée de la région de drain. En outre, une diffusion P 88 est formée dans la couche épitaxiée ou plutôt dans un caisson N de cette couche épitaxiée sous la région en contact avec la portion de silicium polycristallin 85. Ainsi, l'utilisation du silicium polycristallin de base dopé de type P permet de créer une zone de contact de drain de type P⁺, de faire une jonction créée par diffusion solide-solide de très bonne qualité, d'augmenter la résistance d'accès, de ménager un passage de courant au-dessus d'une zone isolante, et de réaliser un contact métallique loin d'une zone sensible constituée par la jonction PN. Cette structure présente l'avantage d'être particulièrement petite pour une tenue donnée aux décharges électrostatiques. Elle est notamment plus petite que les solutions généralement utilisées en technologie purement CMOS.

On a décrit ci-dessus une structure de transistor MOS à canal P. On notera que l'on pourra réaliser une structure similaire de transistor MOS à canal N en utilisant au lieu du silicium polycristallin de base 85, une portion de la couche de silicium polycristallin d'émetteur.

### F. TRANSISTOR MOS HAUTE TENSION

La figure 16 représente une structure de transistor MOS "haute tension" compatible avec la filière selon la présente invention.

En effet, dans la technologie décrite précédemment, les règles d'intégration imposent que les transistors CMOS aient des oxydes de grille très fins, typiquement de l'ordre de 7 nm pour une technologie à dimension minimale de 0,35 µm. Il en résulte que ces transistors MOS supportent seulement des tensions d'alimentation de l'ordre de 3,3 volts.

Cependant, on souhaite disposer d'éléments pouvant résister à des tensions plus élevées, par exemple à des "hautes" tensions de l'ordre de la dizaine de volts, notamment pour constituer des composants d'entrée/sortie.

Pour fabriquer un tel composant, on forme d'abord une couche enterrée de type P⁺ 91 et on ménage, sensiblement en regard de cette couche enterrée, une ouverture 92 dans l'oxyde épais 5. On forme dans cette ouverture un caisson de type P 93, en même temps que les caissons 9 décrits en relation avec la figure 2. Pendant les étapes de formation des transistors CMOS décrites en relation avec la figure 3, le silicium polycristallin de grille n'est pas formé. On réalise cependant avec un masque approprié les diffusions de drain et de source (103 et 104) en même temps que pour le transistor MOS à canal N du CMOS. Lors des étapes de formation de la couche de protection comprenant la couche d'oxyde de silicium 21 et la couche de nitrure de silicium 22, ces couches sont déposées sur l'ouverture formée dans la fenêtre 92. Puis, lors de l'étape de gravure de cette couche de protection, illustrée en relation avec la figure 4, on laisse en place des portions de la couche de protection 21, 22 à la périphérie interne de l'ouverture et dans une région centrale où ces portions 95, 96 des couches 21, 22 formeront l'isolement de grille du transistor haute tension.

En correspondance avec l'étape illustrée en figure 5, on dépose la couche de silicium polycristallin de type P 23 et la couche d'oxyde de protection 24 qui sont laissées en place à des emplacements 97 et 98 correspondant à la région de grille du transistor MOS.

En correspondance avec l'étape illustrée en figure 6, on implante un dopant de type N correspondant au collecteur des transistors bipolaires. Ce dopant pénètre dans les parties ouvertes dans les couches d'oxyde et de nitrure 21 et 22 entre la région centrale 97, 98 et les portions périphériques. Toutefois, cette implantation est sans effet puisqu'elle se localise essentiellement dans la couche enterrée 91 fortement dopée de type P où elle est neutralisée.

En correspondance avec les étapes décrites en relation avec la figure 7, on forme sur les côtés de la grille 95, 96, une région de nitrure de silicium 44 et un espaceur de silicium polycristallin 43.

En correspondance avec l'étape illustrée en figure 8, on dépose une couche de silicium polycristallin dopé de type N qui est maintenue en place aux emplacements désignés par la référence 99, c'est-à-dire notamment au-dessus des zones d'ouverture de la couche de protection 21, 22 et le dopant de type N contenu dans cette couche 99 est amené à diffuser dans le caisson P 93 sous-jacent pour former des régions de reprise de contact de drain et de source 101, 102 qui viennent contacter les régions de drain et de source 103 et 104 formées précédemment.

Les étapes suivantes correspondent à celles décrites précédemment et ne sont pas spécifiques de cette région particulière où est formé le transistor MOS haute tension.

On a donc obtenu un transistor MOS à canal N à grille en silicium polycristallin dopé de type P⁺ non auto-alignée et à source et drain implantés de type N⁺. La reprise des contacts sur ces source et drain se fait par diffusion solide-solide à partir du silicium polycristallin d'émetteur, ce qui assure une meilleure fiabilité des contacts surtout pour une structure haute tension. La tenue en tension des jonctions de source et drain est alors élevée (10 volts).

On notera que l'isolant de grille est formé par un composite d'oxyde de silicium et nitrure de silicium d'une épaisseur totale de l'ordre de 50 nm. L'utilisation d'une grille en silicium polycristallin de type P⁺ permet d'abaisser la tension de seuil du transistor MOS qui reste cependant assez élevée, de l'ordre de 2 volts.

De plus, du fait de la structure mixte (oxyde/nitrure) de l'isolant de grille, un tel dispositif peut servir de point mémoire MIIS (métal-isolant-isolant-semiconducteur) par piégeage de charges à l'interface SiO₂, Si₃N₄.

La double couche 21, 22 pourra être optimisée selon que l'on souhaite former dans le circuit intégré un transistor haute tension ou des points mémoire.

Le transistor MOS haute tension proposé pourra notamment servir dans des circuits analogiques tels que des circuits vidéo et téléphoniques qui utilisent encore des tensions comprises entre 5 et 10 V pour permettre de convertir ces niveaux de 5 à 10 V en signaux de 3,3 V qui peuvent être traités par les composants CMOS obtenus selon l'invention.

Les points mémoire non volatils peuvent être utiles dans des circuits analogiques nécessitant une grande précision, dans lesquels, par exemple, le décalage de tension (offset) d'un amplificateur opérationnel ou la non-linéarité d'un convertisseur analogique/numérique peuvent poser problème. On utilisera alors les points mémoire pour créer un "plan mémoire" de correction.

### G. TRANSISTOR EPROM A DOUBLE GRILLE

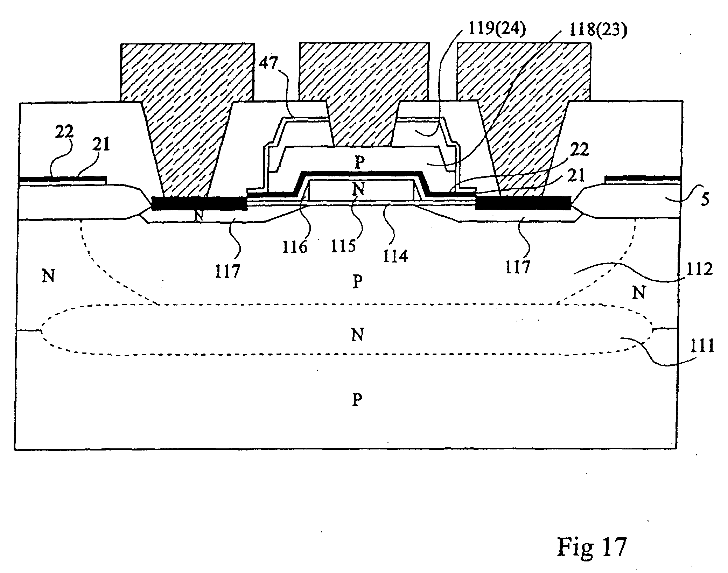

La figure 17 représente une structure de transistor EPROM à double grille à caisson isolé pouvant servir de point mémoire, compatible avec la filière selon la présente invention. Ce point mémoire est formé dans une ouverture ménagée dans la couche d'oxyde épais 5 au-dessus d'une couche enterrée 111 de type N, correspondant à la couche enterrée 3 décrite précédemment, dans un caisson P 112 correspondant au caisson P 9 décrit précédemment. La structure d'isolant de grille 114, de première grille 115, d'espaceurs 116 et de régions de source et de drain 117 correspond à celle d'un transistor MOS à canal N décrit en relation avec la figure 3.

Ensuite, la couche de protection illustrée en figure 4 comprenant la couche d'oxyde 21 et la couche de nitrure 22 est déposée sur la structure et ainsi que les couches de silicium polycristallin de base 23 et d'oxyde d'encapsulation 24, ces deux dernières couches sont laissées en place seulement dans des régions 118 et 119 par la même gravure que celle décrite en relation avec la figure 9. La région 118 s'étend au-dessus de la portion 115 de silicium polycristallin de grille susmentionnée et constitue une deuxième grille isolée par rapport à la première par la couche de protection 21, 22. Après cela, la couche de protection 21, 22 est ouverte au-dessus des régions de drain et de source de la structure, cette ouverture s'étendant au-dessus de l'oxyde épais. On procède alors à une siliciuration des zones apparentes de drain et de source et le processus continue comme pour les autres composants par la formation de couches isolantes et de régions de contact.

Le caisson P 112 est isolé par la couche enterrée 111. Il est donc possible d'injecter des porteurs dans la grille flottante à partir du caisson P, par une polarisation convenable de celui-ci.

L'homme de l'art notera que d'autres composants peuvent être imaginés en utilisant la filière selon la présente invention et que celle-ci est susceptible de diverses variantes et modifications. Notamment, les diverses valeurs numériques indiquées l'ont été uniquement à titre d'exemple et chaque matériau indiqué à titre d'exemple pourra être remplacé par un autre matériau ayant la même fonction (par exemple sélectivité de gravure par rapport à d'autres matériaux). De plus, divers composants élémentaires pourront être réalisés avec ou sans couche enterrée de l'un ou l'autre type de conductivité.

## Revendications

1. Procédé de fabrication d'un circuit intégré comprenant des transistors MOS complémentaires et un transistor bipolaire de type NPN avec les étapes séquentielles :
former une couche épitaxiée (2) de type N sur un substrat (1) de type P, former une couche enterrée (3) dans la zone correspondant au transistor bipolaire avant la formation de la couche épitaxiée de type N,
former une couche d'oxyde épais (5) aux emplacements autres que les emplacements des caissons (8, 9) des transistors MOS, d'une région de puits collecteur (10) du transistor bipolaire et d'une région (11) de base-émetteur du transistor bipolaire,
former les caissons (8, 9) des transistors MOS et le puits collecteur (10) du transistor bipolaire,
former les grilles isolées (13, 14), les espaceurs (15, 16) et les sources et drains des transistors MOS,
recouvrir l'ensemble de la structure d'une couche de protection comprenant une première couche d'oxyde de silicium (21) et une première couche de nitrure de silicium (22),
ouvrir la couche de protection à l'emplacement d'émetteur-base du transistor bipolaire,
former une première couche de silicium polycristallin ou amorphe (23) dopée de type P et une deuxième couche d'oxyde d'encapsulation (24),
ouvrir ces deux dernières couches (23, 24) au centre de la région d'émetteur-base du transistor bipolaire,
faire diffuser le dopant contenu dans la première couche de silicium (23) dans la couche épitaxiée sous-jacente, pour former la base extrinsèque (32) du transistor bipolaire,
implanter un dopant de collecteur de type N (30),
implanter un dopant de type P (33) pour former la base intrinsèque du transistor bipolaire,
déposer une deuxième couche de nitrure de silicium (44), déposer une deuxième couche de silicium polycristallin (43) sur la deuxième couche de nitrure de silicium, graver de façon anisotrope la deuxième couche de silicium polycristallin pour laisser en place des espaceurs dans les portions verticales de celle-ci, et éliminer par une gravure uniforme le nitrure de silicium apparent,
déposer une troisième couche de silicium polycristallin (46) dopée de type N et faire diffuser le dopant pour former l'émetteur du transistor bipolaire,
éliminer les couches se trouvant au-dessus des zones de silicium (50),
procéder à une siliciuration de zones apparentes de drain et de source,
déposer une couche isolante planarisée (51), et
procéder aux métallisations (53-56).

2. Procédé selon la revendication 1, **caractérisé en ce que** la première couche d'oxyde de silicium (21) a une épaisseur de l'ordre de 20 nm et la première couche de nitrure de silicium (22) a une épaisseur de l'ordre de 30 nm.

3. Procédé selon la revendication 1, **caractérisé en ce que** la première couche de silicium (23) a une épaisseur de l'ordre de 200 nm et la deuxième couche d'oxyde de silicium (24) a une épaisseur de l'ordre de 300 nm.

4. Procédé selon la revendication 1, **caractérisé en ce que** la première couche de silicium (23) est obtenue par dépôt de silicium amorphe non dopé puis par implantation superficielle de BF₂.

5. Procédé selon la revendication 1, **caractérisé en ce qu'**une zone superficielle du puits collecteur est dopée en même temps que les sources et drains des transistors MOS à canal N.

6. Procédé selon la revendication 1, **caractérisé en ce que** l'ouverture de la couche de protection à l'emplacement d'émetteur-base est moins étendue que l'ouverture correspondante dans l'oxyde épais.

7. Procédé selon l'une quelconque des revendications 1 à 6 appliqué à la formation d'un transistor PNP latéral, **caractérisé en ce que** :
la région de base correspond à la couche épitaxiée formée au dessus d'une couche enterrée de type N⁺ (3),
la région d'émetteur est formée par la même implantation que les sources et drains des transistors MOS à canal P, et
la région de collecteur est formée à partir d'une portion (72) de la première couche de silicium polycristallin (23).

8. Procédé selon l'une quelconque des revendications 1 à 6 appliqué à la formation d'un transistor MOS résistant aux décharges électrostatiques, **caractérisé en ce que** le contact de drain du transistor MOS est repris par une portion (85) de la première couche de silicium polycristallin s'étendant au-dessus d'une partie du substrat et servant également à établir une diffusion (102) prolongeant la zone de drain (104).

9. Procédé selon l'une quelconque des revendications 1 à 6 appliqué à la formation d'un transistor MOS haute tension, **caractérisé en ce que** :
le transistor MOS haute tension est formé dans un caisson P isolé (112),
la couche d'isolement de grille (95, 96) correspond à une portion de la couche de protection comprenant une première couche d'oxyde de silicium (21) et une première couche de nitrure de silicium (22),
la grille (97) est formée à partir de la première couche de silicium polycristallin dopé (23) et est revêtue de la deuxième couche d'oxyde d'encapsulation (24),
la grille est encadrée latéralement d'espaceurs (43, 99) constitués par la deuxième couche de nitrure de silicium et la deuxième couche de silicium polycristallin, et
les régions de reprise de contact de source et de drain sont formées de zones (101, 102) dopées par diffusion à partir d'un dépôt de portion de la troisième couche de silicium polycristallin.

10. Procédé selon l'une quelconque des revendications 1 à 6 appliqué à la formation d'un transistor EPROM, **caractérisé en ce que** :
la première grille (115), les espaceurs associés et ses source et drain sont formés en même temps que ceux des transistors MOS,
l'isolant entre grilles correspond à une portion de ladite couche de protection (21, 22), et
la deuxième grille (118) correspond à la première couche de silicium polycristallin (23).

## Patentansprüche

1. Verfahren zur Herstellung einer integrierten Schaltung einschließlich komplementärer MOS-Transistoren und einem NPN-Bipolartransistor, wobei das Verfahren die folgenden aufeinanderfolgenden Schritte umfasst:
Bilden einer N-Typ-Epltaxlalschicht (2) auf einem P-Typ-Substrat (1),
Bilden einer tiefliegenden Schicht (3) im Bereich entsprechend dem Bipolartransistor vor der Bildung der N-Typ-Expitaxialschicht,
Bilden einer dicken Oxidschicht (5) an den anderen Stellen als den Stellen der Senken (8, 9) des MOS-Transistors, eines Kollektorsenkenbereichs (10) des Bipolartransistors und eines Basis-Emitter-Bereichs (11) des Bipolartransistors,
Bilden der Senken (8, 9) des MOS-Transistors und der Kollektorsenke (10) des Bipolartransistors,
Bilden der isolierten Gate- oder Steueranschlüsse (13, 14), derAbstandshalter (15, 16) und der Source- und Drain-Anschlüsse der MOS-Transistoren,
Bedecken der gesamten Struktur mit einer Schutzschicht einschließlich einer ersten Schicht aus Siliziumoxid (21) und einer ersten Schicht aus Siliziumnitrid (22),
Öffnen der Schutzschicht an der Basis-Emitter-Stelle des Bipolartransistors,
Bilden einer ersten P-Typ-dotierten Schicht aus polykristallinem oder amorphem Silizium (23) und einer zweiten Schicht aus Einkapselungsoxid (24),
Öffnen der letzteren beiden Schichten (23, 24) an der Mitte des Emitter-Basis-Bereichs des Bipolartransistors,
Diffundieren der in der erster, Siliziumschicht (23) enthaltenen Dotierung in die darunterliegende Epitaxialschicht, um die extrinsische Basis (32) des Bipolartransistors zu bilden,
Implantieren einer N-Typ-Kollektor-Dotierung (30),
Implantieren einer P-Typ-Dotierung (33), um die intrinsische Basis des Bipolartransistors zu bilden,
Abscheiden einer zweiten Schicht aus Siliziumnitrid (44), Abscheiden einer zweiten Schicht aus polykristallinem Silizium (43) auf der zweiten Schicht aus Siliziumnitrid, anisotropes Ätzen der zweiten Schicht aus polykristallinem Silizium, um Abstandshalter an den vertikalen Teilen davon zu hinterlassen, und Beseitigen des freiliegenden Siliziumnitrids durch gleichförmiges Ätzen,
Abscheiden einer dritten N-Typ-dotierten Schicht aus polykristallinem Silizium (46) und Diffundieren der Dotierung, um den Emitter des Bipolartransistors zu bilden,
Beseitigen der Schichten über den Siliziumbereichen (50),
Durchführen einer Silizidierung der freigelegten Drain- und Source-Bereiche,
Abscheiden einer planarisierten Isolierschicht (51), und
Durchführen der Metallisierungen (53-56).

2. Verfahren gemäß Anspruch 1, **dadurch gekennzeichnet, dass** die erste Schicht aus Siliziumoxid (21) eine Dicke von ungefähr 20 nm besitzt, und dass die erste Schicht aus Siliziumnitrid (22) eine Dicke von ungefähr 30 nm besitzt.

3. Verfahren gemäß Anspruch 1, **dadurch gekennzeichnet, dass** die erste Schicht aus Silizium (23) eine Dicke von ungefähr 200 nm besitzt, und dass die zweite Schicht aus Siliziumoxid (24) eine Dicke von ungefähr 300 nm besitzt.

4. Verfahren gemäß Anspruch 1, **dadurch gekennzeichnet, dass** die erste Schicht aus Silizium (23) erhalten wird durch Abscheiden von nichtdotiertem amorphem Silizium und darauffolgendes oberflächliches Implantieren von BF₂.

5. Verfahren gemäß Anspruch 1, **dadurch gekennzeichnet, dass** das Oberflächengebiet der Kollektorsenke gleichzeitig mit den Source- und Drain-Anschlüssen des N-Kanai-MOS-Transistors dotiert wird.

6. Verfahren gemäß Anspruch 1, **dadurch gekennzeichnet, dass** das Öffnen der Schutzschicht an der Emitter-Basis-Stelle in kleinerem Umfang erfolgt als das entsprechende Öffnen in dem dicken Oxyd.

7. Verfahren gemäß einem der Ansprüche 1 bis 6, angewandt auf die Bildung eines lateralen PNP-Transistors, **dadurch gekennzeichnet, dass**
der Basis-Bereich der Expitaxialschicht entspricht, die über der tiefliegenden Schicht des N⁺-Tpys (3) gebildet ist,
der Emitter-Bereich durch die gleiche Implantierung gebildet wird wie die Source- und Drain-Anschlüsse des P-Kanal-MOS-Transistors, und
der Kollektor-Bereich aus einem Teil (72) der ersten Schicht (23) aus polykristallinem Silizium gebildet wird.

8. Verfahren gemäß einem der Ansprüche 1 bis 6, angewandt auf die Bildung eines gegen elektrostatische Entladungen widerstandsfähigen MOS-Transistors, **dadurch gekennzeichnet, dass** der Drain-Kontakt des MOS-Transistors erhalten wird durch einen Teil (85) der ersten Schicht aus polykristallinem Silizium, die sich über einen Teil des Substrats erstreckt und auch dazu verwendet wird, eine den Drain-Bereich (104) verlängernde Diffundierung (102) vorzusehen.

9. Verfahren gemäß einem der Ansprüche 1 bis 6, angewandt auf die Bildung eines Hochspannungs-MOS-Transistors, **dadurch gekennzeichnet, dass**:
der Hochspannungs-MOS-Transistor in einer isolierten P-Senke (112) gebildet wird,
die Gate-isolierende Schicht (95, 96) einem Teil der Schutzschicht entspricht, und zwar einschließlich einer ersten Schicht aus Siliziumoxid (21) und einer ersten Schicht aus Siliziumnitrid (22),
das Gate bzw. der Steueranschluß (97) aus einer ersten Schicht aus dotiertem polykristallinem Silizium (23) gebildet wird und mit der zweiten Schicht aus Einkapslungsoxid (24) überzogen wird,
das Gate seitlich umrahmt ist von Abstandshaltern (43, 99), die durch die zweite Schicht aus Siliziumnitrid und die zweite Schicht aus polykristallinem Silizium gebildet werden, und
die Source- und Drain-Kontaktbildungsbereiche aus Bereichen (101, 102) gebildet werden, die durch Diffundieren aus einer Abscheidung eines Teils der dritten Schicht aus polykristallinem Silizium dotiert werden.

10. Verfahren gemäß einem der Ansprüche 1 bis 6, angewandt auf die Bildung eines EPROM-Transistors, **dadurch gekennzeichnet, dass**:
das erste Gate bzw. der erste Steueranschluß (115), die zugehörigen Abstandshalter und seine Source- und Drain-Anschlüsse gleichzeitig mit denen der MOS-Transistoren gebildet werden,
der Isolator zwischen Gates oder Steueranschlüssen einem Teil der Schutzschicht (21, 22) entspricht, und
das zweite Gate bzw. der zweite Steueranschluß (118) der ersten Schicht aus polykristallinem Silizium (23) entspricht.

## Claims

1. A method for fabricating an integrated circuit including complementary MOS transistors and an NPN-type bipolar transistor, according to claim 1, including the following sequential steps:
forming an N-type epitaxial layer (2) on a P-type substrate (1), forming a buried layer (3) at the location of the bipolar transistor, before the formation of the N-type epitaxial layer,
forming a thick oxide layer (5) at the locations other than the locations of the wells (8, 9) of the MOS transistors, of a collector well region (10) of the bipolar transistor and of a base-emitter region (11) of the bipolar transistor,
forming the wells (8, 9) of the MOS transistors and the collector well (10) of the bipolar transistor,
forming the insulated gates (13, 14), the spacers (15, 16) and the sources and drains of the MOS transistors,
covering the entire structure with a protection layer including a first layer of silicon oxide (21) and a first layer of silicon nitride (22),
opening the protection layer at the base-emitter location of the bipolar transistor,
forming a first P-type doped layer of polysilicon or amorphous silicon (23) and a second layer of encapsulation oxide (24),
opening these last two layers (23, 24) at the center of the emitter-base region of the bipolar transistor,
diffusing the doping contained in the first silicon layer (23) into the underlying epitaxial layer, to form the extrinsic base (32) of the bipolar transistor,
implanting an N-type collector doping (30),
implanting a P-type doping (33) to form the intrinsic base of the bipolar transistor,
depositing a second silicon nitride layer (44), depositing a second layer of polysilicon (43) on the second silicon nitride layer, anisotropically etching the second polysilicon layer to leave in place spacers in the vertical portions thereof, and suppressing the silicon nitride by an uniform etching,
depositing a third N-type doped polysilicon layer (46) and diffusing the doping to form the emitter of the bipolar transistor,
eliminating the layers above the silicon areas (50),
performing a silicidation of the exposed drain and source regions,
depositing a planarized insulating layer (51), and
performing the metallizations (53-56).

2. A method according to claim 1, **characterized in that** the first layer of silicon oxide (21) has a thickness of around 20 nm and the first silicon nitride layer (22) has a thickness of around 30 nm.

3. A method according to claim 1, **characterized in that** the first silicon layer (23) has a thickness of around 200 nm and the second silicon oxide layer (24) has a thickness of around 300 nm.

4. A method according to claim 1, **characterized in that** the first silicon layer (23) is obtained by deposition of undoped amorphous silicon, and then by superficial implant of BF₂.

5. A method according to claim 1, **characterized in that** a surface area of the collector well is doped at the same time as the sources and drains of the N-channel MOS transistors.

6. A method according to claim 1, **characterized in that** the opening of the protection layer at the emitter-base location is of smaller extent than the corresponding opening in the thick oxide.

7. The method of any of claims 1 to 6, applied to the formation of a lateral PNP transistor, **characterized in that**:
the base region corresponds to the epitaxial layer formed above a buried layer of type N⁺ (3),
the emitter region is formed by the same implant as the sources and drains of the P-channel MOS transistors, and
the collector region is formed from a portion (72) of the first polysilicon layer (23).

8. The method of any of claims 1 to 6 applied to the formation of a MOS transistor resisting to electrostatic discharges, **characterized in that** the drain contact of the MOS transistor is recovered by a portion (85) of the first polysilicon layer extending above a portion of the substrate and also used to establish a diffusion (102) continuing the drain area (104).

9. The method of any of claims 1 to 6, applied to the formation of a high voltage MOS transistor, **characterized in that**:
the high voltage MOS transistor is formed in an insulated P well (112),
the gate insulating layer (95, 96) corresponds to a portion of the protection layer including a first layer of silicon oxide (21) and a first layer silicon nitride (22),
the gate (97) is formed from the first layer of doped polysilicon (23) and is coated with the second layer of encapsulation oxide (24),
the gate is laterally framed with spacers (43, 99) formed by the second silicon nitride layer and the second polysilicon layer, and
the source and drain contact recovery regions are formed of areas (101, 102) doped by diffusion from a deposition of a portion of the third polysilicon layer.

10. The method of any of claims 1 to 6 applied to the formation of an EPROM transistor, **characterized in that**:
the first gate (115), the associated spacers and its source and drain are formed at the same time as those of the MOS transistors,
the insulator between gates corresponds to a portion of the protection layer (21, 22), and
the second gate (118) corresponds to the first polysilicon layer (23).
